# EUROPÄISCHE PATENTSCHRIFT

(11) **EP 1 099 221 B1**
(45) Veröffentlichungstag und Bekanntmachung des Hinweises auf die Patenterteilung: **03.07.2002**
(21) Anmeldenummer: 99955732.5
(22) Anmeldetag: 17.09.1999
(51) Int. Cl.: G11C 11/16

(54) **MAGNETORESISTIVER SPEICHER MIT NIEDRIGER STROMDICHTE**
MAGNETORESISTIVE MEMORY WITH LOW CURRENT DENSITY
MEMOIRE MAGNETORESISTIVE A FAIBLE DENSITE DE COURANT

(30) Priorität: 30.09.1998 DE 19845068
(43) Veröffentlichungstag der Anmeldung: 16.05.2001
(73) Patentinhaber: Infineon Technologies AG, 81669 München (DE)
(72) Erfinder: WEBER, Werner, D-80637 München (DE); THEWES, Roland, D-82194 Gröbenzell (DE)
(74) Vertreter: Hoffmann, Jörg Peter, Dr. Ing.
(86) Internationale Anmeldenummer: DE9902983
(87) Internationale Veröffentlichungsnummer: WO0019440

(56) Entgegenhaltungen:
- EP-A- 0 776 011
- EP-A- 0 875 901
- US-A- 4 455 626
- US-A- 5 902 690
- US-A- 5 920 500

## Beschreibung

Die Erfindung betrifft einen magnetoresistiven Schreib-/Lese-Speicher (MRAM), dessen Speichereffekt im magnetisch veränderbaren elektrischen Widerstand der Speicherzelle liegt.

Magnetoresistive Speicher weisen beispielsweise zwischen einer Wort- und einer Bitleitung ein magnetoresistives Schichtensystem auf, das beispielsweise aus einer weichmagnetischen Schicht und einer hartmagnetischen Schicht besteht, die durch ein dünnes Tunneloxid getrennt sind. Der Widerstand zwischen der Bitleitung und der Wortleitung hängt nun davon ab, ob die Magnetisierungsrichtungen in den Materialien parallel oder antiparallel liegen, wobei eine parallele Magnetisierungsrichtung zu einem niedrigeren Widerstandswert und eine antiparallele Magnetisierungsrichtung zu einem höheren Widerstandswert führt. In mehrfacher Hinsicht sind die, insbesondere für das Schreiben einer Zelle erforderlichen, relativ hohen Ströme bzw. Stromspitzen in den Wort- bzw. Bitleitungen von Nachteil, denn die daraus resultierenden Stromdichten führen zu Elektromigrationsproblemen, und einer relativ hohen Verlustleistung. Ferner werden aufgrund der relativ hohen Ströme erhöhte Anforderungen an die Peripherieschaltungen gestellt. Da die Materialien für die Bit- und Wortleitungen beispielsweise prozeßkompatibel, gut strukturierbar und mit geringem spezifischen Widerstand behaftet sein müssen, können Elektromigrationsprobleme durch eine geeignete Wahl der Leitungsmaterialien nur sehr bedingt vermieden werden. Die Reduzierung der erforderlichen Ströme durch Verwendung dünnerer magnetischer Schichten stößt an technologische Grenzen und bedingt mit abnehmender Schichtdicke größere Zuverlässigkeitsprobleme. Darüber hinaus ist aus heutiger Sicht nicht davon auszugehen, daß materialspezifische Optimierungen in absehbarer Zukunft einen signifikanten Beitrag zur Reduktion der erforderlichen Ströme leisten werden.

Aus der US-Patentschrift US 4 455 626 ist ein MRAM bekannt, dessen magnetoresistive Schicht sich in einer Lücke einer dickeren Feldkonzentratorschicht befindet. Eine Speicherschicht und die Feldkonzentratorschicht stellen dabei einen magnetischen Pfad zur magnetoresistiven Schicht dar.

Weiterhin ist aus der EP-A-0 776 011 ein magnetoresistiver Speicher bekannt, in dem ein Material mit hoher Permeabilitätszahl benutzt wird, um eine Erniedrigung der beim Schreiben erforderlichen Stromdichte zu bewirken.

Die der Erfindung zugrundeliegende Aufgabe besteht nun darin, einen magnetoresistiven Schreib-/Lese-Speicher anzugeben, bei dem, bei möglichst geringer Chipfläche, die Stromdichte in den Bit- bzw. Wortleitungen möglichst gering ist.

Diese Aufgabe wird durch die Merkmale des Patentanspruchs 1 oder 4 gelöst. Die weiteren Ansprüche betreffen vorteilhafte Ausgestaltungen der Erfindung.

Nachfolgend werden Ausführungsbeispiele der Erfindung anhand der Zeichnung näher erläutert. Dabei zeigen
- Figur 1A und 1B: zwei zueinander orthogonale Schnitte durch ein erstes Ausführungsbeispiel einer magnetoresistiven Speicherzelle und
- Figur 2B und 2B: zwei zueinander orthogonale Schnitte durch ein zweites Ausführungsbeispiel einer erfindungsgemäßen magnetoresistiven Speicherzelle.

Die Erfindung besteht im wesentlichen darin, daß aufgrund einer verbesserten Einkopplung eines durch die Bitleitungen und/oder die Wortleitungen erzeugten Magnetfeldes in die magnetoresistive Speicherzelle eine geringere Stromdichte in diesen Leitungen erforderlich ist. Durch die Erfindung wird dies auf eine besonders platzsparende und effiziente Weise ermöglicht.

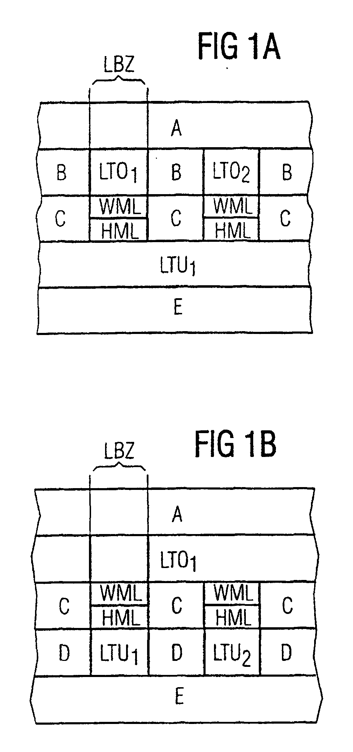

In Figur 1A wird eine Schnittdarstellung im Bereich zweier magnetoresistiver Zellen gezeigt. Derartige magnetoresistive Speicherzellen bestehen beispielsweise aus einer weichmagnetischen Schicht, die durch ein Tunneloxid von einer hartmagnetischen Schicht getrennt ist, wobei die Tunnelwahrscheinlich und damit der elektrische Widerstand zwischen den beiden Schichten von der Magnetisierungsrichtung der beiden Schichten abhängt. Die magnetoresistiven Speicherzellen sind jeweils durch die weichmagnetische Schicht WML und die hartmagnetische Schicht HML angedeutet und befinden sich an Kreuzungspunkten zwischen Bitleitungen und Wortleitungen. Lateral zwischen den Zellen mit den Schichten WML und HML befinden sich Bereiche C, die aus einem elektrisch isolierenden Material mit hoher Permeabilitätszahl bestehen. Darüber hinaus befindet sich lateral zwischen mindestens zwei Leitungen LTO₁ und LTO₂, beispielsweise Bitleitungen, ebenfalls ein Bereich B aus elektrisch isolierendem Material mit hoher Permeabilitätszahl. Der Schnitt von Figur 1B ist orthogonal zum Schnitt von Figur 1A und zeigt darüber hinaus Bereiche D lateral zwischen mindestens zwei Leitungen LTU₁ und LTU₂, beispielsweise Wortleitungen, aus einem elektrisch isolierenden Material mit hoher Permeabilitätszahl. Darüber hinaus ist in Figur 1A und 1B eine durchgehende Schicht A aus einem elektrisch isolierenden Material mit hoher Permeabilitätszahl vorhanden, die direkt an die Bitleitungen LTO₁ und LTO₂ angrenzt, und eine weitere durchgehende Schicht E aus einem elektrisch isolierenden Material mit hoher Permeabilitätszahl vorhanden, die an die Wortleitungen LTU₁ und LTU₂ angrenzt. Auf diese Weise wird gleichzeitig in sehr platzsparender Weise die Isolation der einzelnen Speicherzellen und gleichzeitig eine Feldkonzentration zur Erniedrigung der erforderlichen Stromdichte bewirkt.

Die Schichten A und E und die Bereiche B, C und D können aus unterschiedlichen oder aber auch gleichen elektrisch isolierenden Materialien mit hoher Permeabilitätszahl bestehen. Als Material für diese Schicht A und E und die Bereiche B, C und D eignen sich beispielsweise Ferrite.

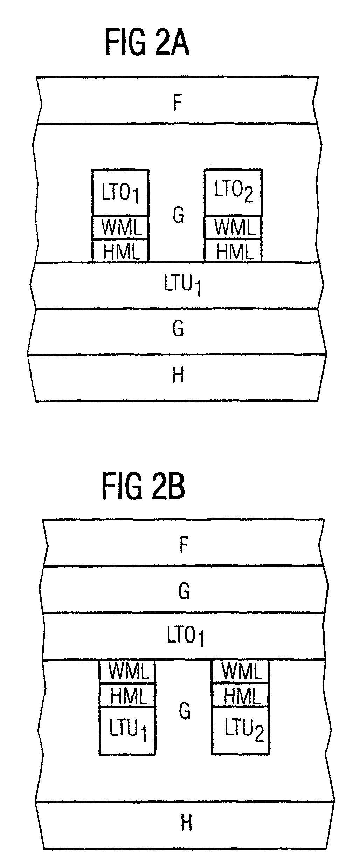

Eine weitere Alternative ist in zwei zueinander orthogonalen Schnitten in Figur 2A und 2B dargestellt, wobei zwischen zwei Schichten F und H aus einem elektrisch leitenden oder schlecht isolierenden Material mit hoher Permeabilität zwei magnetoresistive Speicherzellen dargestellt sind. Der wesentliche Unterschied zur ersten Alternativ ist jedoch, daß die Schichten F und H weder die Bitleitungen noch die Wortleitungen berühren, sondern durch ein elektrisch isolierendes Material mit relativ geringer Permeabilitätskonstante davon getrennt sind. Dies ermöglicht beispielsweise die Verwendung von elektrisch leitenden oder schlecht isolierenden Materialien mit hoher Permeabilitätszahl, da durch das elektrisch isolierende Material die Bit- und Wortleitungen und auch die Speicherzellen selbst nicht kurzgeschlossen bzw. überbrückt werden.

Die Schichten F und H können aus unterschiedlichen oder aber aus gleichen elektrisch leitenden aber auch aus elektrisch nicht leitenden Materialien mit hoher Permeabilitätszahl bestehen. Elektrisch leitende Schichten mit hoher Permeabilitätszahl sind üblicherweise Legierungen aus Eisen, Nickel und/oder Kobalt. Die Schicht G kann den gesamten Raum zwischen den Schichten F und H und den Speicherzellen samt Wortund Bitleitungen ausfüllen. Das Material der Schicht G ist ein elektrischer Isolator mit geringer Permabilitätszahl und besteht beispielsweise aus Siliziumdioxid oder Siliziumnitrid.

In weiteren Ausführungsformen können auch nur die Bereiche B und/oder C und/oder D aus einem elektrisch isolierenden Material mit hoher Permeabilitätszahl, z. B. aus Ferrit bestehen.

## Patentansprüche

1. Magnetoresistiver Speicher, bei dem sich Speicherzellen (WML, HML) samt Bit- und Wortleitungen (LTO1, LTO2; LTU1, LTU2) im lateralen Bereich (LBZ) dieser Speicherzellen zwischen zwei Schichten (A, E) befinden,
**dadurch gekennzeichnet,**
**daß** das Material beider Schichten (A, E) eine hohe Permeabilitätszahl aufweist, und daß zusätzlich lateral zwischen den Bitleitungen (LTO1, LTO2) ein Bereich (B) aus elektrisch isolierendem Material mit großer Permeabilitätszahl und /oder lateral zwischen den Speicherzellen (WML, HML) ein Bereich (C) aus elektrisch isolierendem Material mit großer Permeabilitätszahl und /oder lateral zwischen den Wortleitungen (LTU1, LTU2) ein Bereich (D) aus elektrisch isolierendem Material mit großer Permeabilitäszahl vorhanden ist.

2. Magnetoresistiver Speicher nach Anspruch 1,
**dadurch gekennzeichnet,**
**daß** die zwei Schichten (A, E)) elektrisch isolierend sind und eine der beiden Schichten die Wortleitung und die andere der beiden Schichten die Bitleitung berühren.

3. Magnetoresistiver Speicher nach Anspruch 1 oder 2,
**dadurch gekennzeichnet,**
**daß** mindestens eine der zwei Schichten (A, E, F, H) und/oder der Bereiche (B, C, D) aus Ferrit besteht.

4. Magnetoresistiver Speicher, bei dem sich Speicherzellen (WML, HML) samt Bit- und Wortleitungen (LTO1, LTO2; LTU1, LTU2) im lateralen Bereich dieser Speicherzellen zwischen zwei Schichten (F, H) befinden,
**dadurch gekennzeichnet,**
**daß** das Material beider Schichten (F, H) eine hohe Permeabilitätszahl aufweist und daß zwischen den Speicherzellen samt Bit- und Wortleitungen im Bereich dieser Speicherzellen und mindestens einer der zwei Schichten (F, H) eine Schicht (G) aus einem elektrisch isolierenden Material mit geringer Permeabilitätszahl vorhanden ist.

5. Magnetoresistiver Speicher nach Anspruch 4,
**dadurch gekennzeichnet,**
**daß** der Raum zwischen den zwei Schichten (F, H) und den Speicherzellen samt Bit- und Wortleitungen im Bereich dieser Speicherzellen durch das elektrisch isolierende Material (G) mit geringer Permeabilitätszahl ausgefüllt ist.

## Claims

1. Magnetoresistive memory in which memory cells (WML, HML) together with bit and word lines (LTO1, LTO2; LTU1, LTU2) in the lateral region (LBZ) of these memory cells are situated between two layers (A, E)
**characterized**
**in that** the material of the two layers (A, E) has a high relative permeability, and in that there is additionally present laterally between the bit lines (LTO1, LTO2) a region (B) made of electrically insulating material having a large relative permeability, and/or laterally between the memory cells (WML, HML) a region (C) made of electrically insulating material having a large relative' permeability, and/or laterally between the word lines (LTU1, LTU2) a region (D) made of electrically insulating material having a large relative permeability.

2. Magnetoresistive memory according to Claim 1,
**characterized**
**in that** the two layers (A, E) are electrically insulating and one of the two layers makes contact with the word line and the other of the two layers makes contact with the bit line.

3. Magnetoresistive memory according to Claim 1 or 2,
**characterized**
**in that** at least one of the two layers (A, E, F, H) and/or of the regions (B, C, D) is composed of ferrite.

4. Magnetoresistive memory in which memory cells (WML, HML) together with bit and word lines (LTO1, LTO2; LTU1, LTU2) in the lateral region of these memory cells are situated between two layers (F, H)
**characterized**
**in that** the material of the two layers (F, H) has a high relative permeability, and in that a layer (G) made of an electrically insulating material having a low relative permeability is present between the memory cells together with bit and word lines in the region of these memory cells and at least one of the two layers (F, H).

5. Magnetoresistive memory according to Claim 4,
**characterized**
**in that** the space between the two layers (F, H) and the memory cells together with bit and word lines in the region of these memory cells is filled by the electrically insulating material (G) having a low relative permeability.

## Revendications

1. Mémoire magnétorésistive, dans laquelle des cellules (WML, HML) de mémoire ensemble avec des lignes (LTO1, LTO2 ; LUT1, LTU2) de bits et de mots se trouvent dans la zone (LBZ) latérale de ces cellules de mémoire entre deux couches (A, E),
**caractérisé**
**en ce que** le matériau des deux couches (A, E) a une perméabilité relative qui est élevée et en ce qu'il y a en plus latéralement entre les lignes (LTO1, LT02) de bits une zone (B) en un matériau isolant du point de vue électrique ayant une grande perméabilité relative et/ou latéralement entre les cellules (WML, HML) de mémoire une zone (C) en un matériau isolant du point de vue électrique ayant une grande perméabilité relative et/ou latéralement entre les lignes (LTU1, LTU2) de mots une zone (D) en un matériau isolant du point de vue électrique ayant une grande perméabilité relative.

2. Mémoire magnétorésistive suivant la revendication 1, **caractérisé en ce que** les deux couches (A, E) sont isolantes du point de vue électrique et l'une des deux couches touche la ligne de mots et l'autre des deux couches touche la ligne de bits.

3. Mémoire magnétorésistive suivant la revendication 1 ou 2, **caractérisé en ce qu'**au moins l'une des deux couches (A, E, F, H) et/ou des zones (B, C, D) est en ferrite.

4. Mémoire magnétorésistive, dans laquelle des cellules (WML, HML) de mémoire ensemble avec des lignes (LTO1, LTO2 ; LUT1, LTU2) de bits et de mots se trouvent dans la zone latérale de ces cellules de mémoire entre deux couches (F, H),
**caractérisé**
**en ce que** le matériau des deux couches (F, H) a une grande perméabilité relative et en ce qu'il y a entre les cellules de mémoire ensemble avec des lignes de bits et des lignes de mots dans la région de ces cellules de mémoire et au moins l'une des deux couches (F, H) une couche (G) en un matériau isolant du point de vue électrique ayant une petite perméabilité relative.

5. Mémoire magnétorésistive suivant la revendication 4, **caractérisé en ce que** l'espace entre les deux couches (F, H) et les cellules de mémoire ensemble avec les lignes de bits et de mots est empli dans la région de ces cellules de mémoire du matériau (G) isolant du point de vue électrique ayant une petite perméabilité relative.
